# EUROPEAN PATENT APPLICATION

(11) **EP 4 697 035 A1**
(43) Date of publication of application: **18.02.2026**
(21) Application number: 25187988.8
(22) Date of filing: 08.07.2025
(51) Int. Cl.: G01R 29/08

(54) **SENSOR RECEIVER HAVING A SWEEPING PROBE LASER BEAM GENERATED WITHIN A RYDBERG CELL AND ASSOCIATED METHODS**

(30) Priority: 13.08.2024 US 202418801887
(71) Applicant: Eagle Technology, LLC, Melbourne, FL 32919 (US)
(72) Inventor: BUCKLEW, Victor G., Richmond, 23235 (US); KNARR, Samuel H., Melbourne, 32940 (US); DRAKES, James A., Occoquan, 22125 (US); KANNELL, George, Florham Park, 07932 (US); ESTRADA, Dennis, Palm Bay, 32905 (US); TOWERY, Charles R., Melbourne, 32904 (US)
(74) Representative: Schmidt, Steffen J.

(57) **Abstract**

A sensor receiver **120** may include a Rydberg cell **122** configured to be exposed to a radio frequency (RF) signal **124** and a probe laser source **134** may be configured to generate a sweeping probe laser beam **130** within the Rydberg cell. An optical detector **132** may be downstream from the Rydberg cell **122.**

## Description

### Field of the Invention

The present invention relates to sensor receivers, and, more particularly, to a sensor receiver having a Rydberg cell and sensing atoms contained therein.

### Background of the Invention

Radio frequency (RF) signals are generated and received in communications and sensing applications across a wide range of commercial markets and government divisions. Emerging RF applications are pushing technical requirements to higher frequency ranges with new waveforms that may be difficult to detect and that may need RF receivers or sensors having increased sensitivity. As conventional RF channels become more heavily crowded, there is a need to use alternative RF bands spanning from tens of KHz to 300 MHz and beyond. While some RF receivers and sensors span multiple RF bands, most are bandlimited and can cover only a few tens of GHz, with a typical upper limit of about 40 GHz, e.g., the Ka band. Also, some state-of-the-art RF receivers and sensors are not compatible with new waveforms used in emerging distributed sensing networks and new RF applications that are sensitivity limited, or not served with existing narrow band antenna-based RF receivers and sensors.

Conventional RF devices that incorporate RF antennas may have a high technology readiness level (TRL) and are used in almost every modern RF sensing or communications system. There are limitations with RF antennas, however, because they may be Size, Weight and Power (SWaP) limited. The antenna is also on the order of the RF wavelength of radiation, and the RF coverage is over a relatively narrow frequency band, such as 1-10 GHz or 20-40 GHz. Many conventional RF devices employ antenna designs that are not compatible with emerging waveforms and may lack sensitivity, making them difficult to cover wide bandwidths with high sensitivity.

To address these limitations, Rydberg atom-based RF sensors have been developed, which convert the response of an atomic vapor to incoming RF radiation into measurable changes in an optical probe. These RF sensors provide a new model for RF sensing with increased sensitivity. For example, conventional antennas may provide at most about -130 to -160 dB of sensitivity, but with a Rydberg system, it can be up to about -200 dB with a broader range coverage in a single receiver from KHz to THz.

In a Rydberg atom-based RF sensor, the measurement is based upon the attenuation of a probe laser due to absorption in a small room temperature vapor cell filled with alkali atoms, such as rubidium (Rb) or cesium (Cs). In a two photon/laser Rydberg sensing system, atoms are simultaneously excited into a "Rydberg" state with both a coupling laser and probe laser. These Rydberg states are very responsive to local electric fields and the response of the atom to an external electric field, such as an RF signal, alters the measured attenuation of the probe laser, which may be detected by a probe laser photodetector. The magnitude of the electric field component of the incoming RF radiation and its center frequency detuning from atomic resonance may be determined by measuring the magnitude and asymmetry of spectral splitting of the electromagnetically induced transparency (EIT), which is called Autler Townes (AT) splitting.

Rydberg atom-based RF sensors have emerged as a viable option for surpassing the sensitivity limits of traditional dipole antenna-based receivers, while also reducing the SWaP, and enabling broad frequency coverage. However, current Rydberg sensors may not have realized their theoretical sensitivity limits. The best experimental demonstrations currently provide greater than 35 dB lower sensitivity than theoretical predictions. Accordingly, the best demonstrations may only be on par with traditional RF dipole antenna sensitivities. Some proposals have enhanced bandwidth in a Rydberg RF sensor receiver using a spatiotemporal multiplexing (STM) sensor receiver for high data rate sampling rates. However, there may be limitations in scalability due to SWaP considerations. In that proposed Rydberg STM sensor receiver, bulk optics use a fixed probe laser, and beam splitters and temporal delay lines may sample fresh Rydberg cell atoms in each measurement time.

### Summary of the Invention

A sensor receiver may comprise a Rydberg cell configured to be exposed to a radio frequency (RF) signal. A probe laser source may be configured to generate a sweeping probe laser beam within the Rydberg cell. An optical detector may be downstream from the Rydberg cell. A controller may be associated with the probe laser source to control sweeping of the probe laser beam. The probe laser source may comprise an optical phased array, for example. The optical phased array may comprise a probe laser, and an array of optical phase modulators downstream from the probe laser.

The probe laser source may comprise a probe laser, and an Acousto-Optic Deflector (AOD) downstream from the probe laser. A coupling laser source may be configured to generate a coupling laser beam within the Rydberg cell. The coupling laser source may comprise a coupling laser, and a coupling sweep module downstream therefrom and synchronized with the sweeping probe laser beam.

Another aspect is directed to a method for receiving a radio frequency (RF) signal that may comprise exposing a Rydberg cell to the RF signal and operating a probe laser source to generate a sweeping probe laser beam within the Rydberg cell.

### Brief Description of the Drawings

Other objects, features and advantages of the present invention will become apparent from the detailed description of the invention which follows, when considered in light of the accompanying drawings in which:
FIG. 1 is a schematic diagram of a known Rydberg sensor receiver.
FIG. 2 is a schematic diagram of a Rydberg sensor receiver that generates a sweeping laser beam within a Rydberg cell using an optical phased array according to the invention.
FIG. 3 is a schematic diagram of the sensor receiver showing an array of optical phase modulators to sweep the probe laser beam within the Rydberg cell.
FIG. 4 is a schematic diagram of the sensor receiver showing an acousto-optic deflector to sweep the probe laser beam within the Rydberg cell.
FIG. 5 is a schematic diagram of the sensor receiver showing synchronized probe laser and coupler laser sweep modules to sweep both laser beams within the Rydberg cell.
FIG. 6 is a diagram showing nine-unique laser beam positions within the Rydberg cell that are selected from a 5x5 laser beam array with phase modulators.
FIG. 7 is an image showing a 5x5 array of 780 and 480 nanometer laser beams arranged between the array elements of FIG. 6.
FIG. 8 is a diagram of an example phase profile applied to each laser beam in the array of FIG. 7 that generates far field interference.
FIG. 9 is an image of the end beam profile from the array and phase profile shown in FIGS. 7 and 8.
FIG. 10 is a set of images showing the beginning and end laser beam profiles when the phase profile shown in FIG. 8 is used for steering at 20 MHz the probe laser beam to a first location.
FIG. 11 is a set of images similar to that shown in FIG. 10, but showing a third steered location for the probe laser beam.
FIG. 12 is another set of images showing a sixth steered location for the probe laser beam.
FIG. 13 is another set of images showing a ninth steered location for the probe laser beam.
FIG. 14 is a graph showing 0 Mhz detuning of the probe laser due to the instantaneous frequency being the rate of change of the phase profile when the probe laser beam is shifted to new spatial locations every 20 MHz as shown in FIGS. 10-14.
FIG. 15 is a graph showing 20 MHz detuning of the probe laser.
FIG. 16 is a flowchart showing the method of receiving the RF signal using the sensor receiver of FIGS. 2-5.
FIG. 17 is a schematic diagram of a sensor receiver that uses an actuator to move the sensing atoms with respect to the probe laser beam according to the invention.
FIG. 18 is another schematic diagram of the sensor receiver showing an ultrasonic transducer as the actuator that moves the sensing atoms with respect to the probe laser beam.
FIG. 19 is a flowchart showing a method for receiving an RF signal using the sensor receiver shown in FIGS. 17 and 18.

### Detailed Description

The present description is made with reference to the accompanying drawings, in which exemplary embodiments are shown. However, many different embodiments may be used, and thus, the description should not be construed as limited to the particular embodiments set forth herein. Rather, these embodiments are provided so that this disclosure will be thorough and complete. Like numbers refer to like elements throughout, and prime notation is used to indicate similar elements in different embodiments.

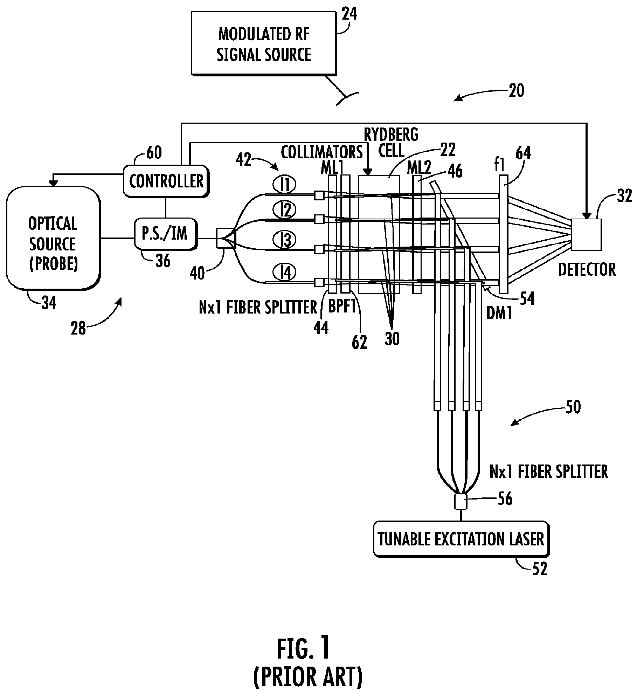

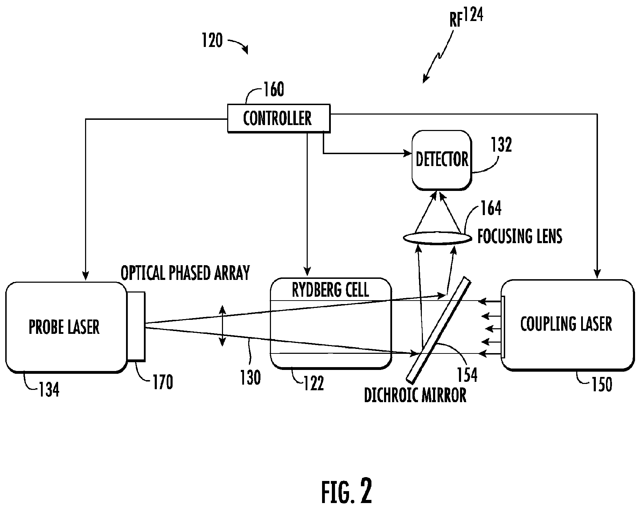

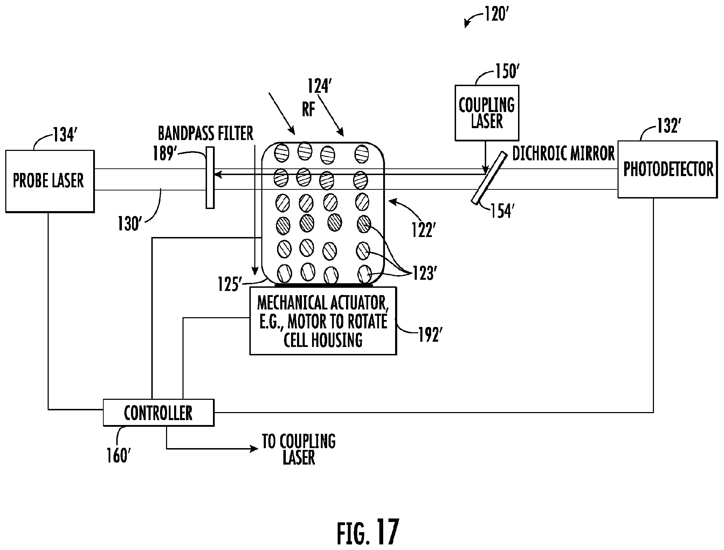

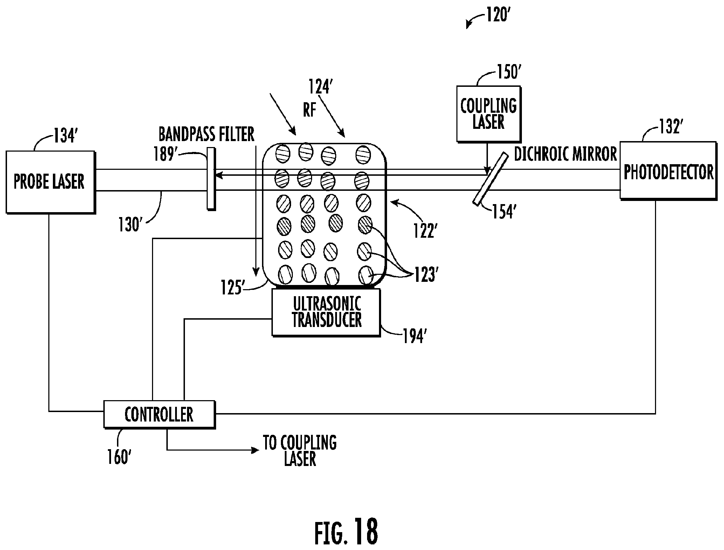

There now follows a description of a known Rydberg sensor receiver that operates as a spatiotemporal multiplexing (STM) Rydberg sensor receiver **20** for high data sampling rate as explained relative to FIG. 1, followed by the approach that increases the number of atoms participating in the measurement, such as by sweeping the probe laser beam within the Rydberg cell as shown in the sensor receiver **120** of FIGS. 2-5, or by moving the sensing atoms contained within the Rydberg cell with respect to the probe laser beam as shown in the sensor receiver **120'** of FIGS. 17 and 18. The approach of moving the sensing atoms contained in the Rydberg cell as described with reference to FIGS. 17 and 18 may be used to boost performance of sweeping the probe laser beam within the Rydberg cell, such that both may be used together.

Referring to FIG. 1, a known spatiotemporal multiplexing (STM) Rydberg sensor, also referred to as a Rydberg sensor receiver, is illustrated generally at **20** and includes a Rydberg cell **22** that is configured to be exposed to a radio frequency (RF) signal generated from a modulated RF signal source **24.** This RF signal source **24** may include a non-modulated RF local oscillator. A laser probe source indicated generally at **28** is configured to generate a plurality of spaced apart pulsed probe beams within the Rydberg cell **22** and generally shown at **30,** with the pulsed probe beams being offset in time from one another. It should be understood that one or more Rydberg cells may be used with the probe beams in multiple Rydberg cells. A detector **32** is positioned downstream from the Rydberg cell **22.** In the illustrated example, the detector **32** is formed from a photodetector cell. The probe source **28** is configured to generate the plurality of spaced apart pulsed probe beams **30** in an example without scanning and may be formed as an optical source **34** with a pulse shaper **36** that is downstream from the optical source. The Rydberg sensor receiver **20** may work with and without scanning the probe beam. The pulse shaper **36** may be an intensity modulator.

In the illustrated example, the probe source **28** includes a beam splitter **40,** such as a Nx1 fiber splitter, downstream from the pulse shaper **36** and a respective optical delay element **42** in a path of each beam downstream from the beam splitter. Each optical delay element **42** may be formed as a respective different length of optical fiber shown by the loops indicated as L1, L2, L3 and L4. A first microlens **44** is positioned adjacent a first side of the Rydberg cell **22** and a second microlens **46** is positioned adjacent a second side of the Rydberg cell as illustrated by the designations ML1 and ML2.

An excitation source **50** as a coupling laser is coupled to the Rydberg cell **22** and formed as a tunable excitation laser **52** and at least one mirror **54,** such as a dichroic mirror downstream therefrom to input the output of the excitation laser and excite the rubidium or cesium used within the Rydberg cell **22.** For a 4-beam version, as shown in FIG. 1, the Nx1 fiber splitter **56** is a 4x1 splitter and may split the output into four beams from the excitation laser **50** corresponding to the illustrated four probe beams **30.** A controller **60** is coupled to the Rydberg cell **22,** the optical source **34** as the laser probe of the probe source **28,** and detector **32.** The delay mechanism may not only delay tunability as noted above, but also direct modulation temporal gating of one or more excitation lasers **52.**

As illustrated, a bandpass filter (BPF1) **62** may be included to block the excitation laser **52** and pass the spaced apart probe beams **30.** This component may be a wavelength division multiplexer or a dichroic mirror. A plano convex lens (f1) **64** may focus the probe beams **30** to the detector **32.** The first microlens **44** and bandpass filter **62** may be formed as a collimator device, e.g., a Thorlabs Part No. 50-780, and have a collimator output with about a 0.5 mm spot size beam at 780 nanometers as generated from the optical source **34** as a laser.

The Rydberg cell **22** is a rubidium Rydberg cell, such as Thorlabs part no. GC19075-RB. Other vapors of specific atomic elements may include Cesium (Cs), Potassium (K), Sodium (Na), and possibly Iodine (I). The Rydberg sensor receiver **20** as illustrated will temporally and spectrally shape the signature of the pulsed probe beams **30,** and thus, allows an increase in the sampling rate as proportional to the number of beams "N." Increasing the sampling rate is also dependent on the probe repetition rate. Separating the probe source **28** as a probe laser beam into N distinct pulses, each of which interrogates a distinct volume of the Rydberg cell **22,** will increase the sampling of an incoming RF field in proportion to the number of beams "N." In addition to increasing the sampling rate, the bandwidth of the probe pulses may also help reduce the latency usually incurred by scanning the probe beam across the EIT spectrum. This may reduce the latency from about 1 to 2 orders of magnitude. The temporal pulse width of the probe determines its spectral bandwidth through a Fourier transform.

It is possible to increase the probe bandwidth generated from the optical source **34** from about 100 KHz to about 200 MHz by choosing an appropriate pulse width. The incoming RF field may be mapped onto a spectroscopic fingerprint without scanning. The Rydberg sensor receiver **20** captures a response directly correlated to the integrated line absorption spectrum, i.e., the equivalent width for the case of the spectral character of the source propagating through the atomic vapor at/near the frequency of an atomic absorption line modified by the pressure of EIT. Further details of the Rydberg sensor **20** described with respect to FIG. 1 are explained in U.S. Patent No. 11,598,798 to Bucklew et al., assigned to Eagle Technology, LLC, the disclosure which is hereby incorporated by reference in its entirety.

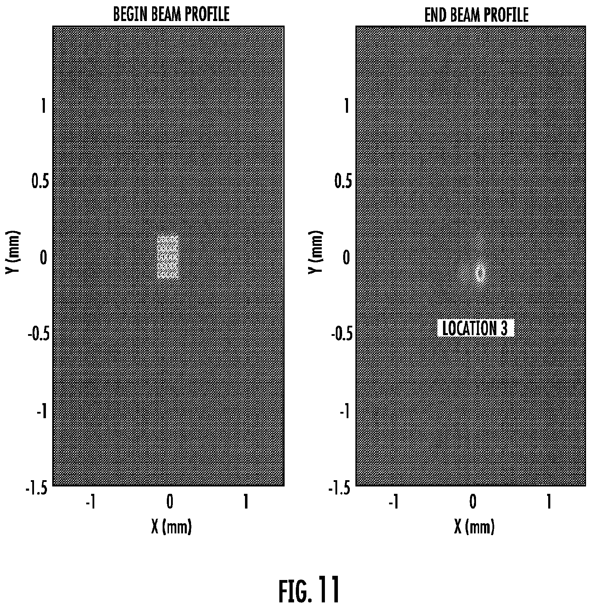

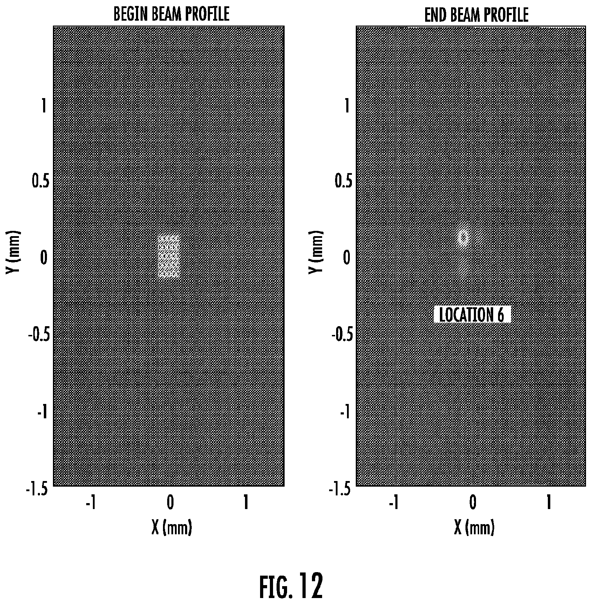

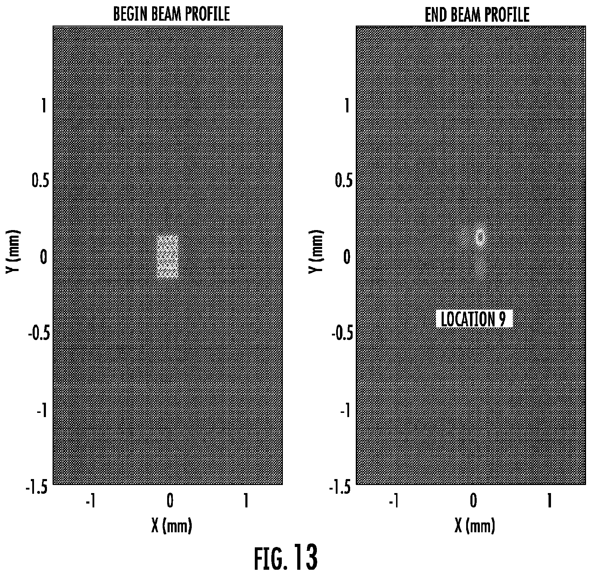

As will be explained with reference to the embodiments shown in FIGS. 2-19, it is possible to bring fresh Rydberg cell sensing atoms with respect to the probe laser beam without using multiple probe laser beams as in the incorporated by reference '798 patent. This can be accomplished by generating and sweeping the probe laser beam within the Rydberg cell or moving the sensing atoms within the Rydberg cell with respect to the probe laser beam. The approach of moving the sensing atoms in the Rydberg cell may be used to boost performance of sweeping the probe laser beam within the Rydberg cell, such that both may be used together. Similar components and elements for the sensor receiver **120,120',** described relative to FIGS. 2-19, are given common reference numerals in the 100 series.

The first embodiment shown in FIGS. 2-16 is directed to the sensor receiver **120** having its probe laser source **134** configured to generate a sweeping probe laser beam **130** within the Rydberg cell **122.** The second embodiment of FIGS. 17-19 shows in detail a configuration of the sensor receiver **120'** where an actuator **190'** is configured to move the sensing atoms **123'** within the Rydberg cell **122'** with respect to the probe laser beam **130'.** The sensor receiver **120'** may also have its probe laser beam **130'** swept since moving the atoms may be used to boost performance, and both may be used together.

As shown in FIG. 2, the sensor receiver **120** includes a Rydberg cell **122** that is configured to be exposed to a radio frequency (RF) signal **124,** such as a modulated communications RF signal. A probe laser source **134** is configured to generate a sweeping probe laser beam **130** within the Rydberg cell **122.** In this example of FIG. 2, the probe laser source **134** includes an optical phased array **170** that operates to generate with the probe laser source the sweeping probe laser beam **130** within the Rydberg cell **122.**

The optical phased array **170** may be formed as a photonic integrated circuit with a beam scanner formed as a polymer waveguide, such as a tunable laser and optical phased array integrated on single or multiple chips. For example, the photonic integrated circuit as a chip may contain a polymer waveguide Bragg reflector, a power splitter, a phase modulator array, and beam concentrator as non-limiting examples. Fluorinated polymer materials may also be used. The probe laser **134** may be integrated in this example into the optical phased array **170,** which allows the probe laser beam **130** to be swept quickly across the Rydberg cell **122.**

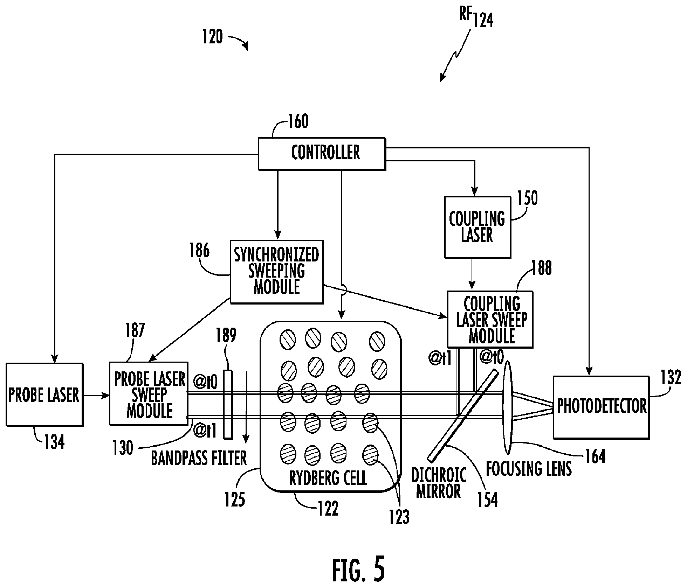

A coupling laser source **150** generates a coupling laser beam that may overfill the Rydberg cell **122** as illustrated diagrammatically with the multiple arrows, so that each spatial end beam position of the probe laser beam **130** within the Rydberg cell **122** pumps the sensing atoms **123** contained within the cell housing **125** of the Rydberg cell (FIG. 5), and pumps the sensing atoms into the Rydberg state, suitable for RF signal **124** measurement. The dichroic mirror **154,** as in the example of FIG. 1, allows the coupling laser beam generated from the coupling laser source **150** to pass through and into the Rydberg cell **122** while also reflecting the probe laser beam **130** from the probe laser source **134** into a focusing lens **164** and into the detector **132,** such as a photodetector. The controller **160** may operate with and be connected to the probe laser source **134,** Rydberg cell **122,** detector **132** and coupling laser source **150** as illustrated. Either a 2-laser or 3-laser excitation system may be used together.

Because the probe laser beam **130** is always interrogating fresh sensing atoms **123** contained within the cell housing **125** of the Rydberg cell **122,** the bandwidth of this sensor receiver **120** is enhanced, and previous measurements do not degrade the signal-to-noise ratio of the RF signal **124** measurement. The focusing lens **164** may capture the probe laser beam **130** and focus it onto the detector **132** at a single spot.

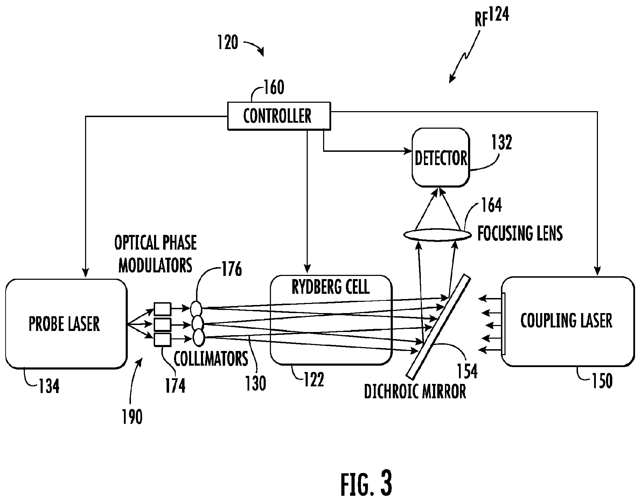

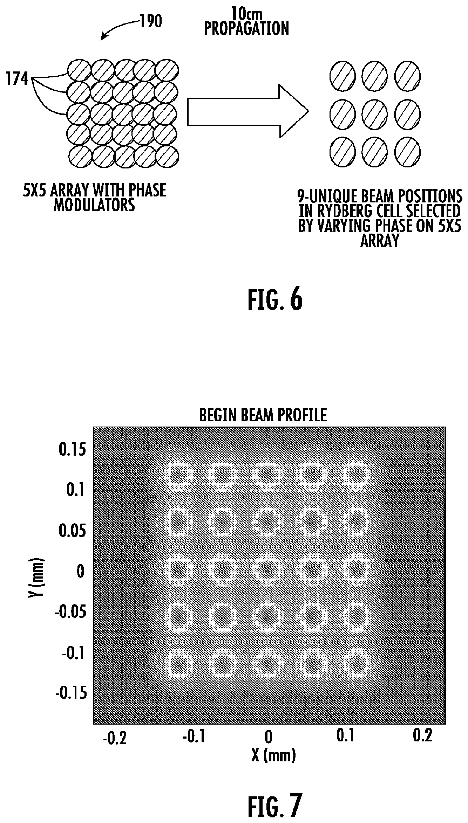

In the example of FIG. 3, optical phase modulators **172** and collimators **174,** each formed from a microlens and bandpass filter, are employed with the probe laser source **134** to sweep the probe laser beam **130** within the Rydberg cell **122.** The optical phase modulators **174** and respective collimators **176** may be part of an optical phased array **170** of the sensor receiver **120** of FIG. 2. Different types of optical phase modulators **174** may be used, such as electro-optic modulators based on pockels cells and liquid crystal modulators. It may be possible to exploit thermally induced refractive index changes or length changes of an optical fiber, or induce length changes in an optical fiber by stretching to impart phase changes. In an example, modulated light may propagate into waveguides and the phase modulators may have spatial control. Although an array **190** of optical phase modulators **174** is shown downstream from the probe laser **134** in FIG. 3, and illustrated as three optical phase modulators and three collimators **176,** this limited number is shown for reference only, and a large plurality of optical phase modulators **174** may be formed in an array downstream from the probe laser, such as the 5x5 array with the phase modulators shown in FIG. 6.

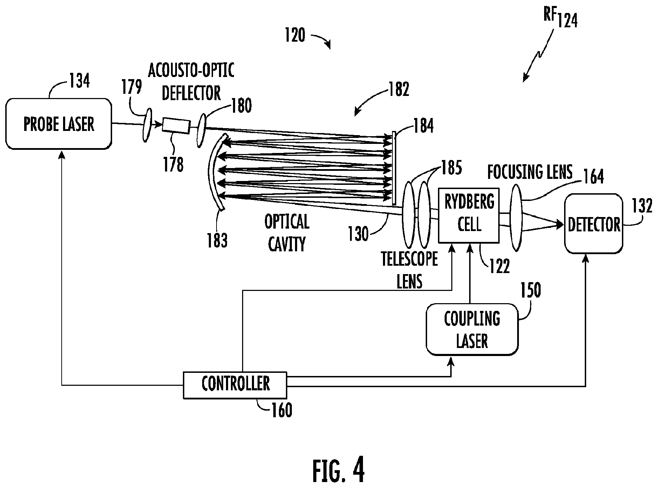

A different example of the sensor receiver **120** that incorporates an acousto-optic deflector (AOD) **178** downstream from the probe laser **134** is shown in FIG. 4. The probe laser beam **130** is generated through an input focusing lens **179** into the acousto-optic deflector **178** and out through an exit focusing lens **180** into an optical cavity **182** formed by optical mirrors, such as a concave mirror **183** and flat mirror **184** shown in FIG. 4. The optical cavity **182** may operate to amplify and deflect the probe laser beam **130** into a pair of telescope lenses **185,** to be swept into the Rydberg cell **122,** where it exits into a focusing lens **164** and detector **132.** The coupling laser source **150** operates similar to the coupling laser source shown in the sensor receiver **120** of FIGS. 2 and 3.

Referring now to the sensor receiver **120** shown in FIG. 5, for reference purposes, the Rydberg cell **122** is shown to include its cell housing **125** and sensing atoms **123** contained therein. A synchronized sweeping module **186** operates with a probe laser sweep module **187** and coupling laser sweep module **188** so that both the probe laser beam **130** and coupling laser beam are spatially swept across the Rydberg cell **122.** The coupling laser sweep module **188** is synchronized with the probe laser sweep module **187** via the synchronized sweeping module **186,** which is controlled via the controller **160,** so that the coupling laser beam and probe laser beam **130** are synchronized to each other. A bandpass filter **189** may be incorporated between the Rydberg cell **122** and the probe laser sweep module **187** and operate to allow a specific probe laser beam to sweep from time t0 to t1. As in the sensor receivers **120** shown in FIG. 2 and 3, a dichroic mirror **154** and focusing lens **164** may be incorporated. The coupling laser sweep module **188** may include one or more lasers to form a multiple laser excitation system.

The probe sweep module **187** and its bandpass filter **189** may sweep the probe laser beam from time t0 through t1, and the coupling laser beam generated from the coupling laser source **150** is swept over the same time from t0 to t1. The number of locations in the Rydberg cell **122** that the coupling laser beam and probe laser beam **130** sweep is chosen so that the Rydberg cell sensing atoms **123** have time to "relax" and "recover" between successive measurements. Optical phased arrays **170** have been demonstrated to operate with 40+ MHz switching speeds. The sensor receiver **120** applies this sweeping technology at specific time scales within the Rydberg cell **122** to enable high data sampling rates in a low SWaP sensor receiver package.

Referring now to FIG. 6, the diagram shows generally at **190** a 5x5 array of optical phase modulators **174** that vary the phase of the probe laser beam **130** to output at the Rydberg cell **122** nine unique probe laser beam **130** positions as shown on the right-hand side of the diagram in FIG. 6. An example array **190** may be a photonic crystal surface-emitting laser (PCSEL) array with a 30 micrometer beam size that is spaced apart by 60 micrometers and spaced 10 centimeters in this example from the Rydberg cell **122** to allow a 10 centimeter laser propagation distance. An image of the 5x5 laser beam array **190** is shown in FIG. 7, which shows an array of 780 nanometer and 480 nanometer laser beams that are each arranged with the desired beam size and spacing in millimeters along the X and Y axis between the array elements. Referring again to FIG. 6, nine unique beam positions in the Rydberg cell **122** as shown in the right-hand side of the diagram may be selected by varying the phase on the optical phase modulators **174** in the 5x5 array **190** using a beam size of about 200 micrometers.

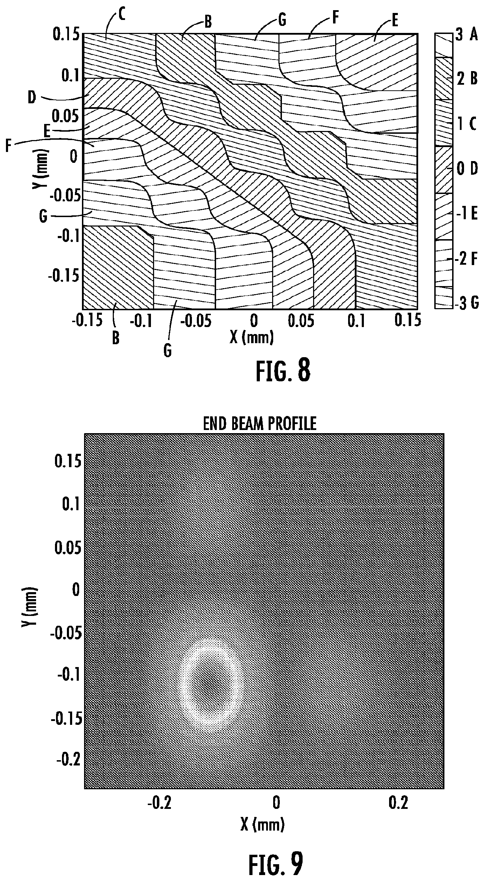

The phase profile as shown in FIG. 8 may be applied to the probe laser beam **130** in the array **190** to generate a far field interference pattern at a position in the Rydberg cell **122** where unique beam locations can be selected on demand. In
FIG. 9, the end beam profile for the probe laser beam **130** at the Rydberg cell **122** is shown where the phase patterns may repeat at every upper state lifetime of the Rydberg sensing atoms **123,** for example, 1 to 2 MHz, and cycle through various patterns at a speed determined by how many independent laser beams are accessible with the array **190** of optical phase modulators **174** forming the beam steering. For example, for a 10-accessible beam position array, and a 2 MHz repetition rate, phased profiles would change every 20 MHz.

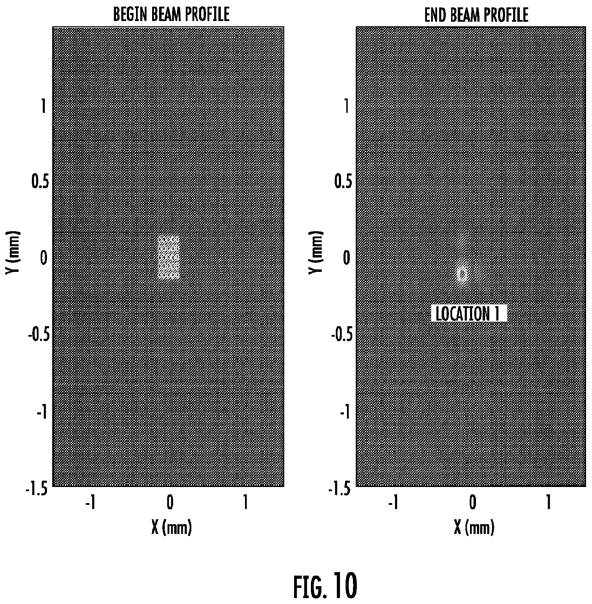

FIGS. 10-13 illustrate four respective sets of images with the beginning beam profile on the left-hand side image and the end beam profile on the right-hand side image. These figures show respective first, third, sixth, and ninth locations where the steering occurs at 20 MHz, i.e., changing the phase pattern every 20 MHz. This results in fresh Rydberg cell **122** sensing atoms **123** being introduced into each measurement.

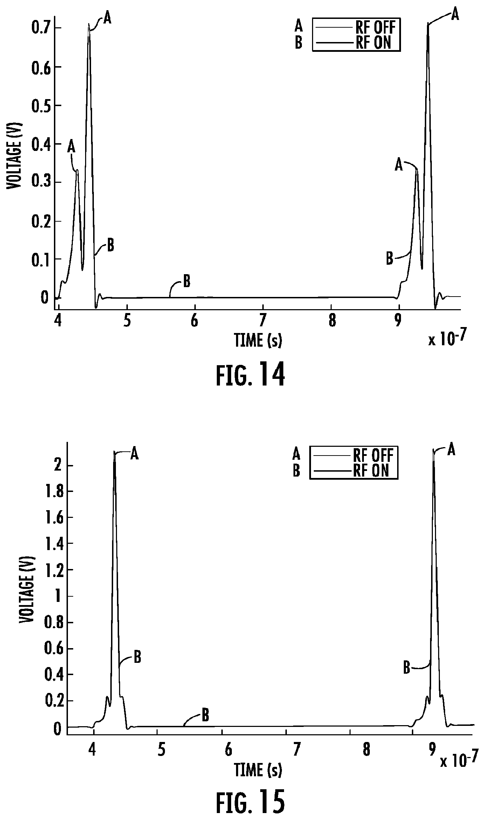

A simulated study of the sensor receiver **120** at a 20 MHz symbol rate is shown in the graphs of FIGS. 14 and 15. In FIG. 14, the graph shows a 0 MHz each detuning of the probe laser **134.** As the phase shifting at the optical phase modulators **174** are applied at 20 MHz in this example, the sensor receiver **120** shifts the probe laser beam **130** to new spatial locations every 20 MHz. This applies a frequency shift on the probe laser **134** due to the instantaneous frequency being the rate of change of the phased profile, and translates to a probe laser detuning of a pulsed probe laser beam **130** at each moment in time.

This process may be simulated as shown in the graphs of FIGS. 14 and 15. As illustrated in those graphs, whether there is no detuning (FIG. 14), or 20 MHz detuning (FIG. 15), there is still an ability to discern between the radio frequency (RF) signal **124** on and off states, which is required for applications involving radio frequency communications, collections, and tracking. The array **190** of laser beams should all have the same frequency shift of about 20 MHz due to the repetitive, linear nature of the applied phase changes.
However, certain patterns may not repeat immediately, and this may require the need to maintain detection of radio frequency signal **124** on and off states between 0 and 20 MHz probe laser detuning that is required as shown in the graphs of FIGS. 14 and 15.

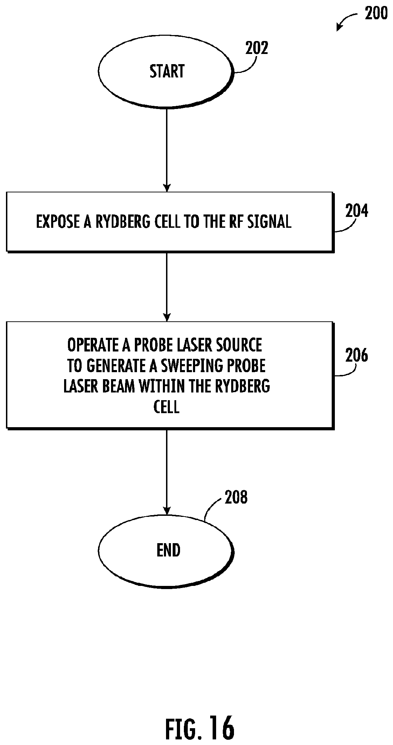

Referring now to FIG. 16, there is illustrated generally at **200** a flowchart showing an example method of receiving a radio frequency (RF) signal **124.** The method starts (Block **202)** and a Rydberg cell **122** is exposed to the RF signal **124** (Block **204).** A probe laser source **134** is operated to generate a sweeping probe laser beam **130** within the Rydberg cell **122** (Block **206).** The process ends (Block **208).**

Referring now to FIG. 17, there is illustrated a sensor receiver **120'** where an actuator **192'** is configured to move the sensing atoms **123'** contained in the cell housing **125'** of the Rydberg cell **122'** with respect to the probe laser beam **130'** generated from the probe laser source **134'.** This sensor receiver **120'** design of moving the atoms may be used to boost performance when the probe laser beam is swept, such that both sweeping of the probe laser beam and moving the atoms are used together. In this example, the actuator **192'** may be formed as a mechanical actuator to move the cell housing **125',** such as a motor to rotate the cell housing **125'** relative to the probe laser beam **130'.** The sensor receiver **120'** includes the optical detector **132'** as an example photodetector downstream from the Rydberg cell **122',** and a bandpass filter **189'** that receives the probe laser beam **130'** into the Rydberg cell. A dichroic mirror **154'** cooperates with the coupling laser source **150'** and probe laser source **134'** so that the probe laser beam **130'** passes therethrough to the photodetector **132'.** The probe laser source **134',** actuator **192',** coupling laser source **150'** and photodetector **132'** are connected to the controller **160'** as in the sensor receiver **120** examples of FIGS. 2-5.

The Rydberg cell **122'** when rotating may continuously sweep away sensing atoms **123'** involved in the measurement, and bring "fresh" sensing atoms into the probe laser beam **130'** to make a measurement, enabling a similarity with a spatiotemporal multiplexing configuration of the prior art example of FIG. 1 without requiring multiple probe laser beams. In the other example shown in FIG. 17, instead of a mechanical actuator **192',** the actuator may be formed as an ultrasonic transducer **194'** that operates as a high-speed megahertz transducer that enables the Rydberg cell **122'** sensing atoms **123'** to circulate and minimize the electron relaxation time to create "fresh" electrons. An example ultrasonic transducer **194'** may be a 3 MHz, 25 millimeter ultrasonic piezo-transducer, such as mounted on aluminum/stainless steel housing sold by Steminc as Part No. SMMSG25F3000.

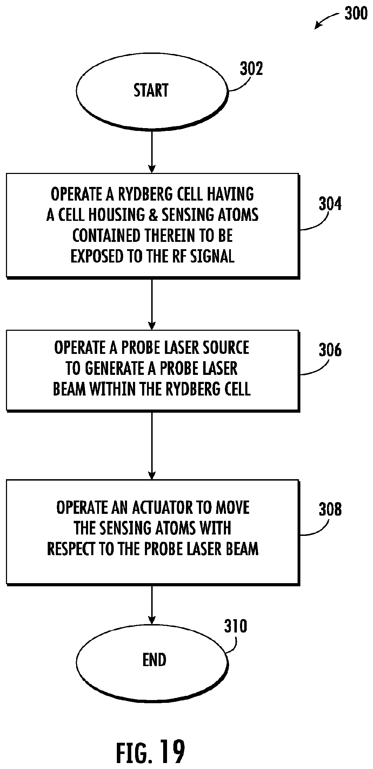

Referring now to FIG. 19, there is illustrated generally at **300** a flowchart showing an example for receiving a radio frequency (RF) signal **124'.** The process starts (Block **302)** and the method includes operating a Rydberg cell **122'** comprising a cell housing **125'** and sensing atoms **123'** contained therein to be exposed to the RF signal **124'** (Block **304).** A probe laser source **134'** is operated to generate a probe laser beam within the Rydberg cell **122'** (Block **306).** An actuator **192'** is operated to move the sensing atoms **123'** with respect to the probe laser beam (Block **308).** The process ends (Block **310).**

This application is related to copending patent applications entitled, **"SENSOR RECEIVER HAVING RYDBERG CELL SENSING ATOMS THAT MOVE WITH RESPECT TO PROBE LASER BEAM AND ASSOCIATED METHODS,"** which is filed on the same date and by the same assignee and inventors, the disclosure which is hereby incorporated by reference.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims.

## Claims

1. A sensor receiver comprising:
a Rydberg cell configured to be exposed to a radio frequency (RF) signal; and
a probe laser source configured to generate a sweeping probe laser beam within the Rydberg cell.

2. The sensor receiver of claim 1, comprising an optical detector downstream from the Rydberg cell.

3. The sensor receiver of claim 1, comprising a controller associated with the probe laser source to control sweeping of the probe laser beam.

4. The sensor receiver of claim 1, wherein the probe laser source comprises an optical phased array.

5. The sensor receiver of claim 4, wherein the optical phased array comprises a probe laser, and an array of optical phase modulators downstream from the probe laser.

6. The sensor receiver of claim 1, wherein the probe laser source comprises a probe laser, and an Acousto-Optic Deflector (AOD) downstream from the probe laser.

7. A method for receiving a radio frequency (RF) signal comprising:
exposing a Rydberg cell to the RF signal; and
operating a probe laser source to generate a sweeping probe laser beam within the Rydberg cell.

8. The method of claim 7, wherein the probe laser source comprises an optical phased array.

9. The method of claim 8, wherein the optical phased array comprises a probe laser, and an array of optical phase modulators downstream from the probe laser.

10. The method of claim 7, wherein the probe laser source comprises a probe laser, and an Acousto-Optic Deflector (AOD) downstream from the probe laser.
